# DEMANDE DE BREVET EUROPEEN

(11) **EP 2 487 091 A1**
(43) Date de publication de la demande: **15.08.2012**
(21) Numéro de dépôt: 12305131.0
(22) Date de dépôt: 06.02.2012
(51) Int. Cl.: B62D 25/06, B60J 7/00

(54) **Dispositif support de panneau solaire photovoltaïque pour véhicule automobile**

(30) Priorité: 10.02.2011 FR 1151062
(71) Demandeur: Renault s.a.s., 92100 Boulogne-Billancourt (FR)
(72) Inventeur: Saint-Leger, Gérard, 78000 VERSAILLES (FR); Demure, Sophie, 92160 ANTONY (FR); Bosnjak, Joseph, 78760 JOUARS PONTCHARTRAIN (FR); Gauthier, Christian Tony, 92200 NEUILLY S/SEINE (FR)

(57) **Abrégé**

Un dispositif support de panneau solaire photovoltaïque (3) pour véhicule automobile, **caractérisé en ce qu'**il comporte un panneau support (5) du panneau solaire photovoltaïque (3), le panneau support étant conformé au toit du véhicule automobile sur lequel il est destiné à être monté, ce panneau (5) comportant sur au moins une partie de sa surface (11) une pluralité de plots (17) destinés à être solidarisés avec une surface inférieure correspondante complémentaire (21) du panneau solaire, de manière à soutenir ce dernier solidairement au panneau support.

## Description

L'invention concerne un dispositif support de panneau solaire photovoltaïque pour véhicule automobile.

On connaît des plaques de panneaux solaires photovoltaïques fixées sur les toits des camping-cars, ces plaques relativement rigides étant disposées sur le toit plat des camping-cars sur un cadre support, fixées à la périphérie de ce dernier. Ce type de montage des panneaux solaires photovoltaïques s'adapte mal à des toits de véhicules incurvés ou nervurés. De plus ils présentent un mauvais aérodynamisme en roulage.

Il existe donc un besoin pour un dispositif support de panneaux solaires photovoltaïques qui résolve au moins en partie les inconvénients de l'art antérieur.

Il est proposé un dispositif support de panneau solaire photovoltaïque pour véhicule automobile, **caractérisé en ce qu'**il comporte un panneau support du panneau solaire photovoltaïque, le panneau support étant conformé au toit du véhicule automobile sur lequel il est destiné à être monté, ce panneau comportant au moins sur une partie de sa surface une pluralité de plots de fixation destinés à être solidarisés avec une surface inférieure correspondante du panneau solaire, de manière à soutenir ce dernier solidairement au panneau support.

Il résulte de cette disposition que les plots créent une structure support en surface du panneau solaire qui permet de soutenir le panneau solaire sur sa surface et non en périphérie comme dans l'art antérieur, et de le soutenir dans des formes adaptées au toit du véhicule, notamment incurvées ou rainurées.

De plus, le risque de flexion du panneau solaire observé sur une fixation périphérique à un cadre en utilisant le dispositif support selon l'invention est moindre que dans l'art antérieur, et de même le risque de casse du panneau solaire est moindre, le panneau solaire étant maintenu de façon plus homogène que celui de l'Art Antérieur.

De préférence, les plots sont positionnés de manière à venir en contact avec des zones passives du panneau solaire à l'écart des points chauds des éléments de cellules photovoltaïques du panneau solaire, ce qui risque de moins fragiliser la liaison entre les plots et le panneau solaire. Ils peuvent par exemple être disposés de manière à soutenir le panneau solaire entre les éléments de cellules photovoltaïques, par exemple aux coins de ces derniers.

De préférence, les plots s'étendent sur toute la surface du panneau support.

Les plots peuvent être disposés de façon régulière sur la surface du panneau, ce qui permet de soutenir le panneau solaire de façon régulière en surface.

Ces plots pourront être tous de même hauteur, supportant alors le panneau solaire en suivant la forme du toit.

On peut également envisager que les plots soient de différentes hauteurs. Le panneau solaire peut alors présenter une forme autre que la forme du toit sur lequel est fixé le panneau support, par exemple présenter une forme plane sur un toit incurvé.

Le panneau support peut comporter des moyens de fixation sur le toit du véhicule, par exemple des vis de fixation aux emplacements réservés à l'installation d'une galerie de toit du véhicule.

Les plots peuvent comporter à l'endroit de leur liaison avec le panneau solaire des éléments adhésifs, par exemple à double face ou à bande adhésive, par exemple des patins adhésifs double face, aptes à s'appliquer en adhérence à la surface inférieure du panneau solaire, mais de préférence ils sont encollés de façon à s'appliquer directement en contact sur le panneau solaire pour le coller .

On peut envisager d'autres méthodes de solidarisation des plots au panneau solaire, notamment aux panneaux solaires souples, par exemple par des vis, rivet, clips ou tout autre moyen approprié.

Diverses méthodes de solidarisation pourront être combinées pour la solidarisation d'un même panneau solaire à un panneau support.

Le panneau support sera de préférence évidé en surface relativement à une partie périphérique formant cadre externe. Les plots de fixation sont alors situés sur la partie évidée de la surface du panneau support. Les moyens de fixation sur le toit du véhicule seront avantageusement situés sur le cadre externe du panneau support. Des trous sont réalisés aux quatre coins du support pour laisser passer l'eau.

Le panneau support est avantageusement issu de moulage en matière synthétique, de préférence de thermoformage de matière thermoplastique, par exemple recyclable. Le panneau pourra être par exemple être thermoformé suivant la forme du toit.

Il est également proposé un ensemble d'un dispositif support tel que décrit ci-dessus et d'un panneau solaire photovoltaïque monté sur le dispositif support, ainsi qu'un véhicule automobile comportant un tel ensemble.

Par ailleurs, le panneau solaire pourra être fixé sur le panneau support de manière à être suffisamment en retrait en hauteur du cadre externe du panneau support pour être protégé mécaniquement par le cadre externe ou contour support, et pour permettre et faciliter la pénétration de l'air entre le panneau solaire et le panneau support lors du roulement du véhicule.

Dans la présente description, le terme « en hauteur » correspond à la direction verticale lorsque le panneau support s'étend dans un plan sensiblement horizontal, ou lorsqu'il est fixé au toit du véhicule.

Avantageusement, une ouverture périphérique est prévue entre le bord du panneau solaire et le panneau support lorsque le panneau solaire est solidarisé au panneau support.

Un mode de réalisation de l'invention est à présent décrit en référence aux dessins annexés sur lesquels :
- la fig. 1 est une vue en perspective éclatée de l'ensemble d'un dispositif support et panneau solaire photovoltaïque selon un mode de réalisation de l'invention,
- la fig. 2 est une vue en perspective de l'ensemble de la figure 1 monté sur le toit d'un véhicule automobile et
- la fig. 3 est une vue partielle en perspective et en coupe de l'ensemble selon la figure 2.

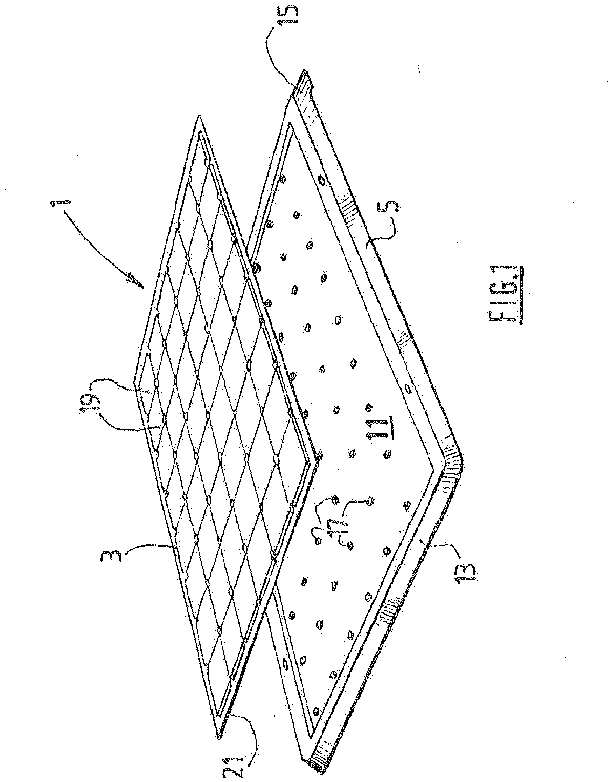

L'ensemble 1 de dispositif support d'un panneau solaire 3 photovoltaïque représenté à la figure 1 comprend un panneau support 5 du panneau solaire et le panneau solaire 3 lui-même.

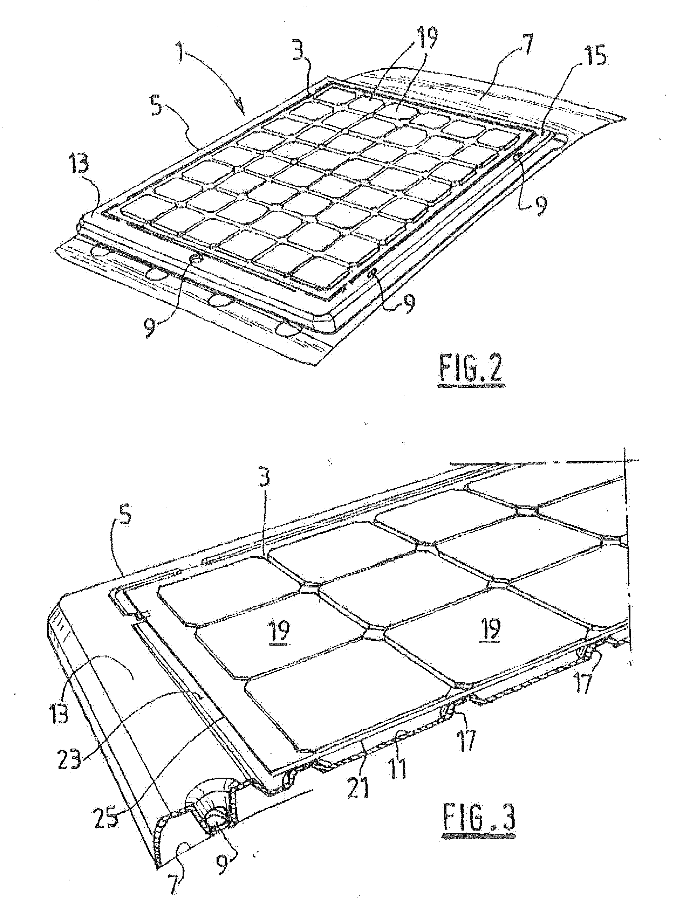

Le panneau support 5 est destiné à être monté sur le toit 7 d'un véhicule automobile, en particulier le toit d'une camionnette (figure 2), que ce toit soit plan comme sur le dessin ou qu'il soit nervuré, rainuré ou incurvé. Dans ce cas, le panneau support 5 est conformé à la forme du toit 7 qu'il épouse.

Ce panneau support 5 peut être monté sur le toit 7 par des vis 9 disposées à la périphérie du panneau et en prise sur le toit 7.

Le panneau support 5 est issu de thermoformage en matière thermoplastique, par exemple de l'ABS/PMMA (acrylonitrile butadiène styrène/polyméthacrylate de méthyle) ou encore en d'autres matières thermoplastiques telles que le polystyrène, le polyéthylène, le polycarbonate, le polychlorure de vinyle, le polystyrène choc. Ce panneau 5 est de forme parallélépipède rectangle de longueur et largeur sensiblement celles du toit 7 du véhicule, respectivement, et de profondeur réduite à quelques centimètres, par exemple 2 à 10 cm. Ce panneau support 5 est évidé en surface 11 relativement à une partie périphérique formant cadre externe 13. Cette surface 11 est une surface plane rectangulaire s'étendant jusqu'au cadre externe 13. L'évidement de la surface 11 relativement au cadre externe 13 est faible, par exemple de 1 à 8 cm en hauteur relativement à la crête du cadre externe 13. Le panneau solaire 3 est logé dans l'évidement 11.

Le bord avant 15 du panneau support correspondant à la partie avant du véhicule est effilé vers le bas de manière à faciliter la pénétration dans l'air du panneau au roulement du véhicule. Le panneau solaire ne déborde pas, il est légèrement en retrait en hauteur pour être protégé mécaniquement par le cadre 13 ou contour support.

Des plots cylindriques 17 sont disposés régulièrement sur la surface 11 du panneau support, et sont destinés à recevoir en engagement le panneau solaire photovoltaïque 3. Ces plots 17 sont implantés en sorte de se trouver à chaque coin (figure 3) des éléments de cellules photovoltaïques 19 du panneau solaire, à savoir dans des endroits neutres ou passifs du panneau solaire et donc à l'écart des points chauds des éléments de cellules photovoltaïques 19.

La hauteur de ces plots (identique de l'un à l'autre) peut être de 1 à 5 cm et leur diamètre varie de 1 à 10 cm.

Ces plots 17 ont leur sommet à forme de disque plan (ou d'une autre forme) destiné à venir chacun en contact adhérent avec la surface inférieure 21 du panneau solaire. Le sommet des plots est en effet revêtu de colle et le panneau solaire est collé sur ces plots.

De préférence, lorsque le panneau solaire est fixé sur le panneau support, il ne déborde pas ou peu en hauteur du cadre externe 13, de manière à faciliter la pénétration dans l'air, au roulement du véhicule, de l'ensemble 1 panneau support et panneau solaire assemblés, cet ensemble étant posé fixé par les vis 9 sur le toit 7 du véhicule (fig.2).

Il est à noter que l'implantation du panneau solaire 3 sur les plots 17 du panneau solaire permet à l'air entre le panneau solaire et le panneau support de circuler et de refroidir les éléments de cellules photovoltaïques 19, cet air pouvant s'échapper par un espace périphérique ou une ouverture périphérique 23 prévue entre le bord 25 du panneau solaire et le panneau support.

Le panneau solaire 3 peut être rigide ou souple. Dans le cas où il est rigide, sa forme est adaptée en correspondance des sommets de plots 17 du panneau support, notamment si le panneau support 5 est cintré ou rainuré selon la forme cintrée ou rainurée du toit du véhicule.

Dans le cas où le panneau solaire 3 est souple, il s'adapte sans difficulté à la forme du panneau support 5 et donc à celle du toit 7 du véhicule.

## Revendications

1. Dispositif support de panneau solaire photovoltaïque (3) pour véhicule automobile, comportant un panneau support (5) du panneau solaire photovoltaïque (3), le panneau support étant conformé au toit (7) du véhicule automobile sur lequel il est destiné à être monté, le panneau support (5) comportant sur au moins une partie de sa surface (11) une pluralité de plots de fixation (17) destinés à être solidarisés avec une surface inférieure correspondante (21) du panneau solaire, de manière à soutenir ce dernier solidairement au panneau support, ledit dispositif support étant **caractérisé en ce que** les plots (17) sont positionnés de manière à venir en contact avec des zones passives du panneau solaire (3) à l'écart des points chauds des éléments de cellules photovoltaïques (19) du panneau solaire.

2. Dispositif support selon la revendication 1, **caractérisé en ce que** les plots (17) sont disposés de façon régulière sur la surface (11) du panneau support.

3. Dispositif support selon la revendication 1 ou 2, **caractérisé en ce que** le panneau support (5) comporte des moyens de fixation (9) sur le toit (7) du véhicule, par exemple des vis de fixation (9) aux emplacements réservés à l'installation d'une galerie de toit du véhicule.

4. Dispositif support selon l'une quelconque des revendications précédentes, **caractérisé en ce que** les plots (17) comportent à l'endroit de leur liaison avec le panneau solaire (3) des éléments adhésifs, par exemple à double face, apte à s'appliquer directement en collage sur le panneau solaire (3).

5. Dispositif support selon l'une quelconque des revendications 1 à 3, **caractérisé en ce que** les plots (17) sont encollés de façon à s'appliquer directement en contact sur le panneau solaire (3) pour le coller.

6. Dispositif support selon l'une quelconque des revendications précédentes, **caractérisé en ce que** le panneau support (5) est évidé en surface (11) relativement à une partie périphérique formant cadre externe (13).

7. Ensemble d'un dispositif support selon l'une quelconque des revendications précédentes et d'un panneau solaire photovoltaïque (3) solidarisé au dispositif support.

8. Ensemble selon la revendication 7, **caractérisé en ce qu'**une ouverture périphérique (23) est prévue entre le bord (25) du panneau solaire (3) et le panneau support (5) lorsque le panneau solaire est solidarisé au panneau support.

9. Véhicule automobile comportant un ensemble (1) selon la revendication 7 ou 8.
